# EUROPÄISCHE PATENTSCHRIFT

(11) **EP 2 575 175 B1**
(45) Veröffentlichungstag und Bekanntmachung des Hinweises auf die Patenterteilung: **26.04.2017**
(21) Anmeldenummer: 12186374.0
(22) Anmeldetag: 27.09.2012
(51) Int. Cl.: H01L 27/146, H01L 23/00

(54) **Bildsensor mit großer Chipfläche**
Image sensor with large chip size
Détecteur d'images ayant une puce de grandes dimensions

(30) Priorität: 30.09.2011 DE 202011106207 U
(43) Veröffentlichungstag der Anmeldung: 03.04.2013
(73) Patentinhaber: First Sensor Microelectronic Packaging GmbH, 01109 Dresden (DE)
(72) Erfinder: Schneider, Werner, 01277 Dresden (DE); Woldt, Gregor, 01187 Dresden (DE)
(74) Vertreter: Lippert Stachow Patentanwälte Rechtsanwälte

(56) Entgegenhaltungen:
- WO-A1-2010/095367
- DE-C1- 10 055 040
- US-A- 5 952 714
- US-A1- 2008 191 335
- US-A1- 2008 251 872

## Beschreibung

Die Erfindung betrifft einen Bildsensor mit einer Chipfläche von >100 mm², enthaltend einen auf einem Chipträger zentrisch angeordneten Bildsensor-Chip mit an dessen Peripherie angeordneten Drahtbondpads.

Für Bildsensoren mit großer Chip- bzw. Sensorfläche werden als Träger zumeist Keramikgehäuse in Form von BGA (Ball Grid Array)-, Chip-Carrier (CC) oder QFP (Quad Flat Package) -Gehäusen in entsprechend großen Abmessungen eingesetzt.

So zeigt die DE 10 2005 059 161 A1 ein optisches Modul mit einem in einem Keramikgehäuse montierten Bildsensor, der über Drahtbrücken mit Kontaktpads im Gehäuse elektrisch verbunden ist. Über dem Bildsensor befindet sich eine optische Einrichtung, die in einem Linsenhalter montiert ist und die mit dem Keramikgehäuse dicht verbunden ist, um das Eindringen von Wasserdampf zu verhindern.

Als große Bildsensoren werden solche angesehen, die eine Chipfläche von >100 mm² aufweisen. Die Gehäuse für solche Bildsensoren müssen dann entsprechend dimensioniert werden.

Die Verwendung von CC - Gehäusen ohne Metallpins am Gehäuse ist problematisch, da eine beträchtliche Fehlanpassung der thermischen Ausdehnungskoeffizienten zwischen dem Gehäuse und dem Substrat, auf welches das Gehäuse gelötet ist, vorliegt. Die Folge sind Ausfälle durch Rissbildung, Delaminierung sowie thermo-mechanische Spannungen und eine nicht zu tolerierende Gehäuse- und damit Chipkrümmung.

Außerdem bauen keramische Bauelemente der o.g. Bauform mit einer Dicke von typisch >3 mm relativ dick bzw. besitzen eine verhältnismäßig große Bauhöhe, wie z.B. aus der DE 10 2005 059 161 A1 ersichtlich ist.

Weiterhin führt die Lötbelastung bei der Montage von Keramikgehäusen in einem Reflowprozess zu einer hohen thermischen Belastung des Bildsensors und auch der Klebeverbindungen Glas zu Gehäuse, die überlastet werden können.

Im Falle der Direktmontage von großen Bildsensoren auf dem PCB (Printed Circuit Board) in COB (Chip on Board)- Technologien werden diese auf Grund der Fehlanpassung der thermischen Ausdehnungskoeffizienten thermo-mechanisch belastet und verkrümmen sich, was zu schlechteren optischen und mechanischen Eigenschaften führt.

Aus der US 2008/191335 A1 ein CMOS-Bildsensor bekannt geworden, bei dem ein Sensorchip in einer Durchgangsöffnung in einem Substrat mittels eines Klebstoffs fixiert ist, der zugleich als Schutz für die Rückseite des Chips dient. Die Kanten und die Rückseite des Chips sind somit in den Klebstoff eingebettet. Der Klebstoff ist ein lichtempfindliches Material, ein Kunstharzmaterial oder Silikongummi, der in den Spalt zwischen dem Rand des Chips und der Durchgangsöffnung eingefüllt und auf die Rückseite des Chips aufgetragen wird.

Auf dem Sensorchip befindet sich ein Mikrolinsengebiet, das durch eine dielektrische Schicht umrahmt wird. Auf der dielektrischen Schicht befindet sich eine transparente Abdeckung. Innerhalb der dielektrischen Schicht befinden sich Drahtbondverbindungen. Diese Konstruktion ist auf einer Leiterplatte montiert und wird zusätzlich durch einen kappenförmigen Linsenhalter abgedeckt.

Weiterhin geht aus der US 2008/251872 A1 ein Image Sensor hervor, bei dem ein Sensorchip in einer Vertiefung eines transparenten Substrates montiert ist und zwar derart, dass dieses über Außenanschlüsse mit Verbindungselementen des Substrates elektrisch verbunden ist. Der Spalt zwischen den Kanten des Sensorchips und dem Substrat ist mit einem Klebstoff ausgefüllt, der beim Einbringen erhitzt wird.

Damit ist die Empfängerfläche des Sensorchips vor der Verschmutzung mit feinen Partikeln geschützt.

In der US 5 952 714 A wird ein Package mit einen CCD-Sensor beschrieben, bei dem das Sensor-Chip in einer Vergussmasse eingebettet ist, wobei dessen Bumps mit einem Leadframe durch Löten verbunden sind. Die Vergussmasse spart dabei den zentralen Bereich des CCD-Chips aus.

Dabei können periphere Bauelemente und ein Sensor-Chip nebeneinander auf einem Substrat angeordnet sein, das über Bumps mit dem Leadframe elektrisch verbunden ist. Der Spalt zwischen den Kanten des Substrates und dem Package ist mit einem mit UV härtbaren Kunstharz ausgefüllt.

Das Dokument WO2010/095367A1 offenbart ebenfalls einen Bildsensor, bei dem der Bildsensor-Chip auf dem Chipträger mittels Epoxy geklebt wird. Die Größe des Bildsensor-Chips wird nicht angegeben.

Schließlich wird in der DE 100 55 040 C1 ein Verfahren zur Befestigung eines elektrischen Schaltungsträgers auf einer Platte, insbesondere für Schaltungsträger aus Keramik beschrieben. Danach wird zum Aufkleben eines Schaltungsträgers auf der Keramikplatte zunächst ein Kleber nicht flächig aufgebracht. Anschließend wird der Schaltungsträger aufgesetzt/angeheftet und danach unter Druckbeaufschlagung vollflächig verklebt. Bei der Druckbeaufschlagung kann die Keramikplatte brechen.

Das wird dadurch vermieden, dass Kleberbahnen beispielsweise in Form eines Kreuzes aufgetragen werden und dass das Andruckwerkzeug mit hervorstehenden Andruckflächen versehen ist, die ebenfalls in Form eines Kreuzes mit einem zentralen Andruckpunkt und vier Andruckpunkten im jeweiligen Endbereich der Kleberbahnen versehen ist. Auf diese Weise wird der Kleber beim Zusammendrücken gleichmäßig ohne störende Lufteinschlüsse verteilt. Außerdem werden bei diesem Prozess Biegekräfte klein gehalten.

Der Erfindung liegt die Aufgabe zugrunde, einen Bildsensor mit großer Bildfläche zu schaffen, der kostengünstig herstellbar ist und einen stressarmen Aufbau mit möglichst geringer Chipkrümmung ermöglicht.

Die der Erfindung zugrunde liegende Aufgabe wird bei einem Bildsensor der eingangs genannten Art dadurch gelöst, dass der Bildsensor-Chip mit einem duktilen Kleber zentrisch auf den Chipträger geklebt ist, dass sich auf dem Chipträger Drahtbondpads neben dem Bildsensor-Chip befinden, dass der Chipträger mit einem duktilen Kleber auf den Schaltungsträger geklebt ist, dass der Bildsensor-Chip außerhalb der sich neben diesem befindlichen Drahtbondpads durch einen Rahmen umgeben ist, der einstückig am Chipträger angeformt oder mit diesem durch Kleben mit einem duktilen Kleber fest verbunden ist, wobei auf dem Rahmen ein Filter oder eine Glasplatte mit einem duktilen Kleber geklebt ist, dass für die elektrische Verbindung von auf dem Bildsensor-Chip befindlichen Drahtbondpads und Drahtbondpads auf dem Chipträger und Drahtbondpads auf dem Schaltungsträger jeweils Drahtbrücken vorgesehen sind, und dass der Chipträger und der Rahmen aus Keramik, Glas oder Silizium bestehen, wobei die Keramik, das Glas oder das Silizium ähnliche thermische Ausdehnungskoeffizienten wie der Bildsensor-Chip haben.

Durch die Erfindung wird ein stressarmer Aufbau mit möglichst geringer Chipkrümmung erreicht, wobei insbesondere der Rahmen die mechanische Steifigkeit des Bildsensors insbesondere gegen einwirkende Biegekräfte deutlich erhöht. In einer ersten Fortbildung der Erfindung befinden sich auf dem Chipträger mindestens zwei Reihen von inneren Drahtbondpads, zwischen denen der Bildsensor-Chip befestigt ist, sowie mindestens zwei weitere Reihen von äußeren Test- und Drahtbondpads jeweils entlang der Peripherie des Chipträgers.

In einer alternativen Ausführungsform ist der Schaltungsträger mit einer Kavität versehen, in welcher der Chipträger vertieft angeordnet ist, so dass sich die Bauhöhe des Bildsensors deutlich verringert. Die Abmessungen der Kavität müssen so gewählt werden, dass der Chipträger verspannungsfrei eingesetzt werden kann. Es ist auch möglich, den Chipträger mit einer Kavität zur Aufnahme des Bildsensors zu versehen.

In einer anderen alternativen Ausführung ist der Chipträger unter dem Schaltungsträger angeordnet, der in diesem Fall mit einer Öffnung über dem Bildsensor-Chip versehen ist. Die Öffnung muss so groß sein, dass die Bildsensor-Fläche uneingeschränkt frei liegt.

In einem Beispiel, das nicht Teil der beanspruchten Erfindung ist, kann der Rahmen auch in der Peripherie des Schaltungsträgers angeordnet werden, so dass dieser sowohl die Test- und Drahtbondpads, als auch den Chipträger umgibt. Wird nun diese Ausführung mit der vertieften Anordnung des Chipträgers im Schaltungsträger oder des Bildsensors im Chipträger kombiniert, wird die geringst mögliche Bauhöhe erreicht.

Weiterhin ist es auch möglich, unmittelbar auf die Bildsensorfläche Filter oder eine Glasplatte direkt und/oder organische bzw. anorganische Schichten als Einzelschichten oder Schichtkombinationen aufzubringen.

Der Schaltungsträger kann eine übliche gedruckte Leiterplatte sein, oder aus einem glasfaserverstärkten Kunststoff oder einem Keramikmaterial bestehen, was eine hohe Biegesteifigkeit gewährleistet.

Zumindest die Drahtbondverbindungen zwischen dem Bildsensor-Chip und dem Chipträger sind zu deren Schutz durch einen Filter bzw. eine Glasplatte abgedeckt.

Um die Stabilität der Drahtbondverbindungen gegen mechanische Belastungen, wie Erschütterungen, zu erhöhen, können sämtliche Drahtbondverbindungen auch in eine Vergussmasse eingebettet sein. Mit der Abdeckung der Drahtbondverbindungen und der Drahtbondpads können reflektierende Flächen (vergoldete Drahtbondpads) beseitigt werden. Hierfür kommen die für diesen Zweck üblicherweise eingesetzten Kunststoffmaterialien in Betracht.

Die Erfindung wird nachfolgend an einem Ausführungsbeispiel näher erläutert.

In den zugehörigen Zeichnungsfiguren zeigen:
- Fig. 1:: eine perspektivische schematische Schnittdarstellung eines erfindungsgemäßen Bildsensors mit großer Chipfläche;
- Fig. 2:: eine perspektivische Schnittdarstellung einer weiteren Ausführung, bei der der Bildsensorchip in einer Kavität im Chipträger angeordnet ist;
- Fig. 3:: eine perspektivische Schnittdarstellung einer weiteren Ausführung nach Fig. 2, bei der der Chipträger unter einer Öffnung im Schaltungsträger angeordnet ist; und
- Fig. 4:: eine perspektivische Schnittdarstellung einer Ausführung des erfindungsgemäßen Bildsensors, bei der der Chipträger in einer Kavität im Schaltungsträger angeordnet ist.

Der Bildsensor enthält einen großen Bildsensor-Chip 2 mit einer Chipfläche von >100mm², beispielsweise 20 mm x 30 mm, der mittels eines ersten Klebstoffs 5 auf einem Chipträger 7 elektrisch leitend oder nichtleitend befestigt ist.

Auf dem Bildsensor-Chip 2 befinden sich an der Peripherie entlang von zwei einander gegenüberliegenden Rändern jeweils Reihen von Drahtbondpads 13 neben der eigentlichen Sensorfläche, die über erste Drahtbondverbindungen 4 mit entsprechenden Drahtbondpads 14, die sich neben dem Bildsensor-Chip 2 auf dem Chipträger 7 befinden, elektrisch verbunden sind. Die Drahtbondpads 13 können auch entlang der vier Ränder des Bildsensor-Chips 2 angeordnet sein. Die Enden der Drahtbondverbindungen 4 sind durch ein geeignetes Drahtbondverfahren auf die Drahtbondpads geschweißt (gebondet). Hierfür kommt Ultraschalldrahtbonden, oder auch Thermosonicbonden in Betracht. Die Auswahl eines der bekannten Drahtbondverfahren hängt von dem Material der verwendeten Bonddrähte sowie der Drahtbondpads 13 ab, die aus Aluminium, Gold, Kupfer, oder anderen geeigneten Materialien bestehen können.

Am Außenrand des Chipträgers 7 sind auf dessen Oberseite Test- und Drahtbondpads 8 angeordnet, die entsprechend mit den innen liegenden Drahtbondpads 14 über nicht dargestellte an der Oberfläche des Chipträgers 7 oder oberflächennah verlaufende Leitbahnen elektrisch verbunden sind.

Diese Test- und Drahtbondpads 8 dienen zum Testen des Bildsensors und gleichzeitig als Kontaktierungspads für die elektrische Verbindung zu einer Schaltung zur Bildverarbeitung o. dgl. über Drahtbondverbindung 9 zu den Drahtbondpads 10 auf einem Schaltungsträger 12. Die Test- und Drahtbondpads 8 auf dem Chipträger 7 ermöglichen eine Messung bzw. den Test des Bildsensor-Chips 2 vor der Endmontage auf dem Schaltungsträger 12. Damit können im Fehlerfall weitere kostspielige Montageschritte vermieden werden.

Der Chipträger 7 ist mittels eines zweiten duktilen Klebstoffes 11 auf dem Schaltungsträger 12 befestigt.

Auf dem Schaltungsträger 12, der gewöhnlich als Leiterplatte ausgebildet ist, befinden sich am Rand mindestens jeweils eine Reihe von Drahtbondpads 10, die über Drahtbondverbindung 9 mit der Drahtbondpads 8 auf dem Chipträger verbunden sind. Der Schaltungsträger 12 kann auch aus einem mit Glasfasern verstärktem Kunststoff, oder einem Keramikmaterial bestehen.

Außen um die Drahtbondpads 14 auf dem Chipträger 7 herum ist ein Rahmen 6 angeordnet, der mit dem Chipträger 7 durch Kleben fest verbunden ist. Der Rahmen 6 dient als Abstandshalter zur Aufnahme eines Filters oder einer Glasplatte 1, die zugleich die Bildsensor-Fläche 3 des Bildsensor-Chips 2 schützt. In der Zeichnungsfigur sind nur die seitlichen Teile des Rahmens 6 ersichtlich. Der Rahmen 6, der als Abstandshalter dient, hat zugleich eine stabilisierende Funktion für den Bildsensor.

Für die Montage des Filters oder der Glasplatte 1 auf dem Rahmen 6, bzw. des Rahmens 6 auf dem Chipträger 7 wird ein duktiler Klebstoff verwendet, der die Fehlanpassung der Ausdehnungskoeffizienten der einzelnen Bestandteile des Bildsensors ausgleichen kann.

Die besonderen Merkmale dieses Bildsensors sind in einem besonders einfachen Aufbau zu sehen, der sich speziell für die stressarme Montage großer Bildsensor-Chips 2 eignet. Der somit erreichte stressarme Aufbau weist nach der Montage eine äußerst geringe Chipkrümmung auf, die bei der Montage von CMOS-Bildsensoren, LCOS (Liquid Crystal on Silicon), Photodiodenarrays und anderen optischen Sensoren unerlässlich ist.

Es werde Chipträger 7 aus Keramik, Glas oder Silizium eingesetzt, die ähnliche thermische Ausdehnungskoeffizienten aufweisen, wie der Bildsensor-Chip 2. Auch der Rahmen 6 besteht aus solchen Materialien.

Die Montage auf dem Schaltungsträger 12, der typisch eine Leiterplatte mit Signalverarbeitungsbausteinen ist, die mit SMD-Bausteinen (SMD: Surface Mounted Device) bestückt ist, erfolgt vor der Montag des Bildsensors, so dass der Bildsensor-Chip 2 keine Lötbelastung erfährt.

Wegen der insgesamt geringen thermo-mechanischen Belastung, da die Lötbelastung weggefallen ist, kann der Filter bzw. die Glasplatte 1 dünner ausgeführt werden. Der Vorteil ist, dass der Gesamtaufbau flacher gestaltet werden kann.

Die Verbindung zwischen Chipträger 7 und Schaltungsträger 12, z.B. in Form einer bestückten Leiterplatte, erfolgt ebenfalls über Drahtbbondverbindung 9, die ausreichend robust sind.

Außerdem kann der Chipträger 7 aktive oder passive Bauelemente (z.B. Kondensatoren) als SMD-Bauelemente oder in Dickschichtausführung enthalten, die innerhalb oder außerhalb des Rahmens 6 angeordnet werden können.

Der komplette Bildsensor ist durch die einfache Montage kostengünstig herstellbar.

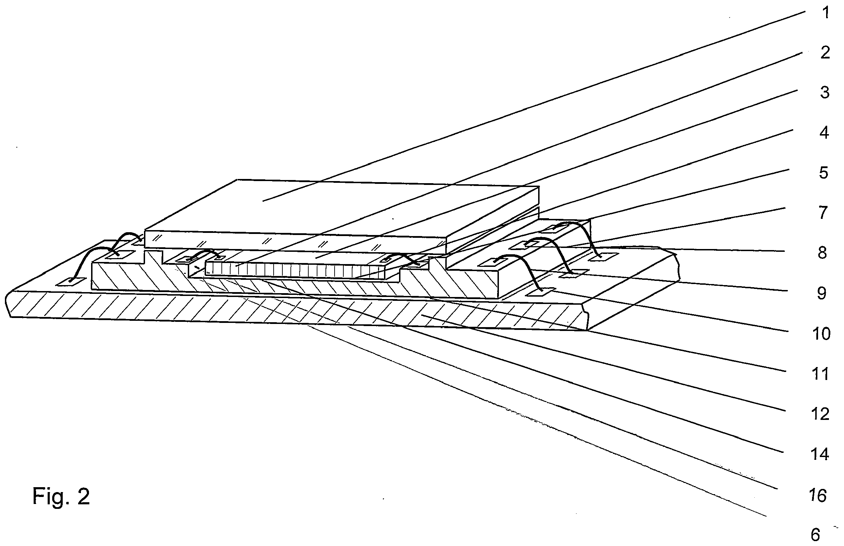

In Fig. 2 ist eine Variante des Bildsensors dargestellt, bei welcher der Bildsensorchip 2 in einer Kavität 16 im Chipträger 7 angeordnet ist. Der Rahmen 6 kann in diesem Fall niedriger ausgeführt werden, als bei der Ausführung nach

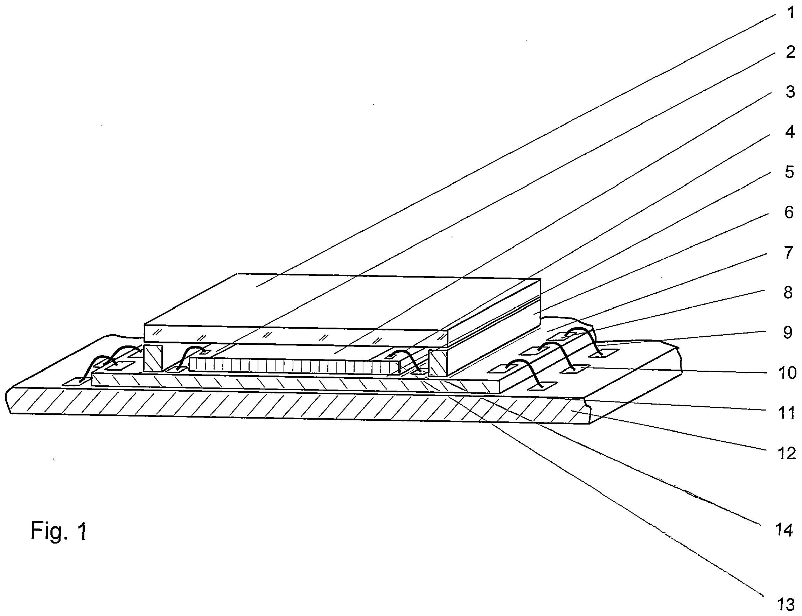

Fig. 1, so dass der Bildsensor insgesamt niedriger baut. Der Rahmen 6, auf dem der Filter 1 bzw. die Glasabdeckung angeordnet ist, kann auch einstückig am Chipträger 7 angeformt sein, wie aus Fig. 2 ersichtlich ist.

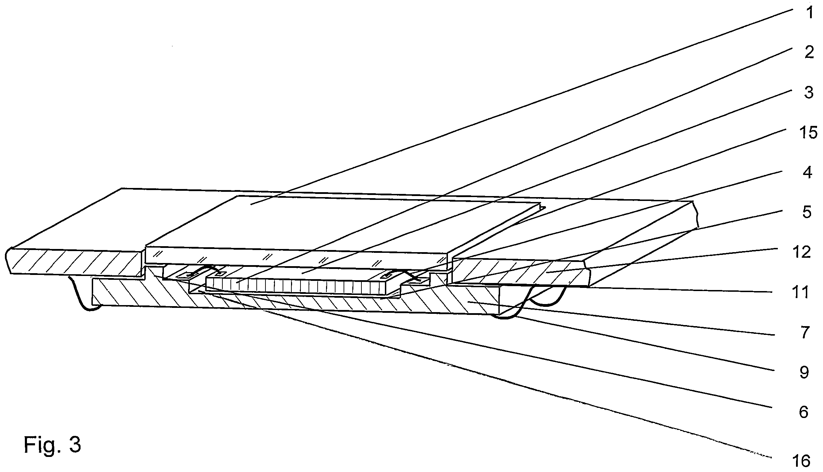

Es ist auch möglich, den Chipträger 7 auf der Rückseite des Schaltungsträgers 12 anzuordnen, wobei der optische Bereich sich dann durch eine Öffnung 15 im Schaltungsträger 12 erstreckt, so dass das einfallende Licht den auf dem Chipträger 7 befindlichen Bildsensor-Chip 2 erreichen kann (Fig. 3). Die Öffnung 15 im Schaltungsträger 12 muss kleiner sein, als der Umriss des Chipträgers 7, damit dieser am Schaltungsträger befestigt werden kann. Andererseits muss die Öffnung 15 aber so groß sein, dass der vormontierte und verdrahtete Chipträger 7 mit dem Bildsensor-Chip 2 und aufgesetztem Filter bzw. Glasplatte 1 von unten in den Schaltungsträger 12 eingesetzt werden kann. Der Chipträger 7 ist hier ebenfalls mit einer Kavität 16 zur Aufnahme des Bildsensor-Chips 2 versehen. Die Drahtbondverbindungen 9 zwischen Chipträger 7 und Schaltungsträger 12 befinden sich in diesem Fall auf der Unterseite des Bildsensors.

Der Rahmen 6 kann hier ebenfalls einstückig am Chipträger 7 angeformt sein, oder als separates Bauteil auf den Chipträger 7 geklebt sein, auf den der Filter bzw. die Glasplatte 1 geklebt ist. Der Rahmen 6 hat hier ebenfalls eine stabilisierende Funktion und dient auch dazu, den nötigen Freiraum für die Drahtbondverbindungen 4 zwischen dem Bildsensor-Chip 2 und dem Chipträger 7 unter dem Filter bzw. der Glasplatte 1 zu schaffen.

Der Vorteil dieser Variante ist, dass der Bildsensor sehr flach baut und eine nahezu ebene Oberfläche besitzt.

Die Rückseite des Schaltungsträgers 12 kann zusätzlich auch mit einer Kühleinrichtung (nicht dargestellt) zur Kühlung des Bildsensor-Chips 2 versehen werden. Im Fall, dass der Chipträger 7 unter dem Schaltungsträger 12 angeordnet ist, ist die Kühleinrichtung entsprechend auf der Rückseite des Chipträgers 7 zu montieren. Die Kühleinrichtung kann ein für ähnliche Fälle üblicher Kühlkörper sein.

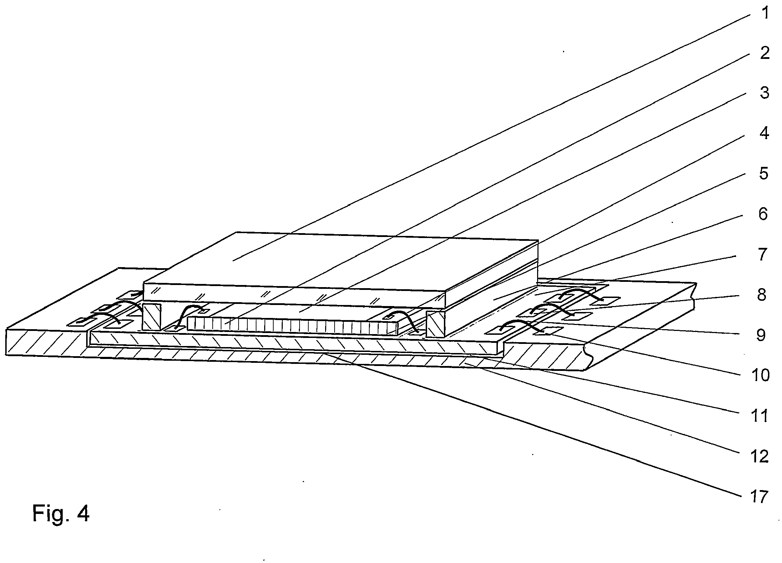

Alternativ kann der Chipträger 7 auch in eine Kavität bzw. Vertiefung 17 im Schaltungsträger 12 eingebaut werden (Fig. 4), so dass dadurch eine Verringerung der Gesamtdicke des Bildsensors erreicht wird. Die Abmessungen der Kavität müssen so gewählt werden, dass der Chipträger 7 verspannungsfrei hineinpasst. Ansonsten entspricht der Aufbau des Bildsensors nach Fig. 1.

In einem Beispiel, das hilfreich für das Verständnis der vorliegenden Erfindung ist, kann die optische Abdeckung optional auch entfallen, wenn die Bildsensor-Fläche 3 mit einer Passivierung mit ausreichender Härte versehen wird, die einen hinreichenden Schutz vor mechanischen und chemischen Belastungen bietet. Auch können als Abdeckung oder Passivierung des Bildsensor-Chips 2 auch Glas/Filter 1 und organische bzw. anorganische Schichten direkt auf die Bildsensorfläche 3 als Einzelschichten oder als Schichtkombinationen aufgebracht werden.

In einem Beispiel, das hilfreich für das Verständnis der vorliegenden Erfindung ist, ist es Z auch möglich, die Kontaktierung zwischen Chipträger 7 und Schaltungsträger 12 mit Hilfe von speziellen Klemmfassungen vorzunehmen.

Weiterhin kann eine Abdeckung der Drahtbondverbindungen 9 zwischen Chipträger 7 und Schaltungsträger 12 mit den bekannten Materialien, z.B. durch Vergießen, oder mit mechanischen Komponenten, erfolgen.

Die optische Abdeckung mit dem Filter/Glas 1 kann auch so angeordnet werden, dass die Drahtbondverbindungen 9 zum Schaltungsträger 12 mit abgedeckt werden, wobei der Rahmen 6 gleichzeitig als Handlingschutz dient.

In diesem Fall muss der Rahmen 6 auf der Peripherie des Schaltungsträgers 12 unmittelbar an dessen Rand angeordnet werden.

Für sämtliche vorstehend beschriebenen Klebeverbindungen wird ein duktiler Klebstoff verwendet.

### Bezugszeichenliste

- 1: Filter/Glas
- 2: Bildsensor-Chip
- 3: Bildsensor-Fläche
- 4: Drahtbondverbindung
- 5: erster Klebstoff
- 6: Rahmen
- 7: Chipträger
- 8: Test- und Drahtbondpad
- 9: Drahtbondverbindung
- 10: Drahtbondpad Board/Schaltungsträger
- 11: zweiter Klebstoff
- 12: Schaltungsträger
- 13: Drahtbondpad
- 14: Drahtbondpad
- 15: Öffnung
- 16: Kavität im Chipträger
- 17: Kavität im Schaltungsträger

## Patentansprüche

1. Bildsensor mit einer Chipfläche von >100 mm², enthaltend einen auf einem Chipträger zentrisch angeordneten Bildsensor-Chip mit an dessen Peripherie angeordneten Reihen von Drahtbondpads, wobei
- der Bildsensor-Chip (2) mit einem duktilen Kleber auf den Chipträger (7) geklebt ist,
- sich auf dem Chipträger (7) Drahtbondpads (14) neben dem Bildsensor-Chip (2) befinden,
- der Chipträger (7) mit einem duktilen Kleber auf den Schaltungsträger (12) geklebt ist,
- der Bildsensor-Chip (2) außerhalb der sich neben diesem befindlichen Drahtbondpads (14) durch einen Rahmen (6) umgeben ist, der einstückig am Chipträger (7) angeformt oder mit diesem durch Kleben mit einem duktilen Kleber fest verbunden ist,
- wobei auf dem Rahmen (6) ein Filter oder eine Glasplatte (1) mit einem duktilen Kleber geklebt ist,
- für die elektrische Verbindung von auf dem Bildsensor-Chip (2) befindlichen Drahtbondpads (13) und Drahtbondpads (14) auf dem Chipträger (7) und Drahtbondpads (10) auf dem Schaltungsträger (12) jeweils Drahtbrücken vorgesehen sind, und
- der Chipträger (7) und der Rahmen (6) aus Keramik, Glas oder Silizium bestehen, wobei die Keramik, das Glas oder das Silizium ähnliche thermische Ausdehnungskoeffizienten wie der Bildsensor-Chip (2) haben.

2. Bildsensor nach Anspruch 1, wobei sich auf dem Chipträger (7) mindestens zwei Reihen von inneren Drahtbondpads (14) befinden, zwischen denen der Bildsensor-Chip (6) befestigt ist, sowie mindestens zwei weitere Reihen von äußeren Test- und Drahtbondpads (8) jeweils entlang der Peripherie des Chipträgers (7).

3. Bildsensor nach Anspruch 1 und 2, wobei der Schaltungsträger (12) mit einer Kavität (17) versehen ist, in welcher der Chipträger (7) eingelassen ist.

4. Bildsensor nach Anspruch 1 und 2, wobei der Chipträger (7) mit einer Kavität (16) zur Aufnahme des Bildsensor-Chips (6) versehen ist.

5. Bildsensor nach einem der Ansprüche 1 bis 3, wobei der Chipträger (7) unter dem Schaltungsträger (12) angeordnet ist, der mit einer Öffnung (15) über dem Bildsensor-Chip (2) versehen ist.

6. Bildsensor nach einem der Ansprüche 1 bis 5, wobei unmittelbar auf die Bildsensorfläche (2) Filter oder eine Glasplatte (1) direkt und/oder organische bzw. anorganische Schichten als Einzelschichten oder Schichtkombinationen aufgebracht sind.

7. Bildsensor nach einem der Ansprüche 1 bis 6, wobei der Schaltungsträger (12) eine gedruckte Leiterplatte ist, die aus einem glasfaserverstärkten Kunststoff oder einem Keramikmaterial besteht.

8. Bildsensor nach einem der Ansprüche 1 bis 7, wobei zumindest die Drahtbondverbindungen (4) zwischen dem Bildsensor-Chip (2) und dem Chipträger (7) durch den Filter bzw. die Glasplatte 1 abgedeckt sind.

9. Bildsensor nach einem der Ansprüche 1 bis Z 8, wobei sämtliche Drahtbondverbindungen (4, 9) in einer Vergussmasse eingebettet sind.

## Claims

1. Image sensor with a chip area of > 100 mm², containing an image sensor chip arranged centrally on a chip carrier with series of wire bonding pads arranged at the periphery of said image sensor chip, wherein
- the image sensor chip (2) is adhesively bonded onto the chip carrier (7) by means of a ductile adhesive,
- on the chip carrier (7) wire bonding pads (14) are situated alongside the image sensor chip (2),
- the chip carrier (7) is adhesively bonded onto the circuit carrier (12) by means of a ductile adhesive,
- the image sensor chip (2) is surrounded by a frame (6) outside the wire bonding pads (14) situated alongside said image sensor chip, said frame being integrally formed on the chip carrier (7) or fixedly connected thereto by adhesive bonding by means of a ductile adhesive,
- wherein a filter or a glass plate (1) is adhesively bonded on the frame (6) by means of a ductile adhesive,
- wire bridges are in each case provided for the electrical connection of wire bonding pads (13) situated on the image sensor chip (2) and wire bonding pads (14) on the chip carrier (7) and wire bonding pads (10) on the circuit carrier (12), and
- the chip carrier (7) and the frame (6) consist of ceramic, glass or silicon, the ceramic, the glass or the silicon having coefficients of thermal expansion similar to that of the image sensor chip (2).

2. Image sensor according to Claim 1, wherein
on the chip carrier (7) there are situated at least two series of inner wire bonding pads (14), between which the image sensor chip (6) is fixed, and also at least two further series of outer test and wire bonding pads (8) in each case along the periphery of the chip carrier (7).

3. Image sensor according to Claims 1 and 2, wherein the circuit carrier (12) is provided with a cavity (17) in which the chip carrier (7) is incorporated.

4. Image sensor according to Claims 1 and 2, wherein the chip carrier (7) is provided with a cavity (16) for receiving the image sensor chip (6).

5. Image sensor according to any of Claims 1 to 3, wherein the chip carrier (7) is arranged below the circuit carrier (12), which is provided with an opening (15) above the image sensor chip (2).

6. Image sensor according to any of Claims 1 to 5, wherein filters or a glass plate (1) directly and/or organic and/or inorganic layers as individual layers or layer combinations are applied directly to the image sensor area (2).

7. Image sensor according to any of Claims 1 to 6, wherein the circuit carrier (12) is a printed circuit board which consists of a glass fibre reinforced plastic or a ceramic material.

8. Image sensor according to any of Claims 1 to 7, wherein at least the wire bonding connections (4) between the image sensor chip (2) and the chip carrier (7) are covered by the filter or the glass plate (1).

9. Image sensor according to any of Claims 1 to 8, wherein all of the wire bonding connections (4, 9) are embedded in a potting compound.

## Revendications

1. Capteur d'image ayant une surface de puce supérieure à 100 mm², comportant une puce de capteur d'image disposée de manière centrale sur un support de puce et ayant des rangées de plots de connexion par fils disposées à sa périphérie, dans lequel
- la puce de capteur d'image (2) est collée au moyen d'un adhésif ductile au support de puce (7),
- des plots de connexion par fils (14) se trouvent à côté de la puce de capteur d'image (2) sur le support de puce (7),
- le support de puce (7) est collé au moyen d'un adhésif ductile sur le support de circuit (12),
- la puce de capteur d'image (2) est entourée par un cadre (6) à l'extérieur des plots de connexion par fils (14) se trouvant à côté de celle-ci, lequel cadre est formé d'un seul tenant sur le support de puce (7) ou est fermement relié à celui-ci par collage au moyen d'un adhésif ductile,
- dans lequel un filtre ou une lame de verre (1) est collé au moyen d'un adhésif ductile au cadre (6),
- des ponts de fils respectifs sont prévus pour la connexion électrique de plots de connexion par fils (13) se trouvant sur la puce de capteur d'image (2), de plots de connexion par fils (14) sur le support de puce (7) et de plots de connexion par fils (10) sur le support de circuit (12), et
- le support de puce (7) et le cadre (6) sont constitués de céramique, de verre ou de silicium, dans lequel la céramique, le verre ou le silicium ont des coefficients de dilatation thermique semblables à celui de la puce de capteur d'image (2).

2. Capteur d'image selon la revendication 1, dans lequel au moins deux rangées de plots de connexion par fils (14) internes se trouvent sur le support de puce (7), entre lesquelles est fixée la puce de capteur d'image (6), ainsi qu'au moins deux autres rangées de plots de connexion de test et par fils (8) externes respectivement situées le long de la périphérie du support de puce (7).

3. Capteur d'image selon les revendications 1 et 2, dans lequel le support de circuit (12) est muni d'une cavité (17) dans laquelle est incorporé le support de puce (7).

4. Capteur d'image selon les revendications 1 et 2, dans lequel le support de puce (7) est muni d'une cavité (16) destinée à recevoir la puce de capteur d'image (6).

5. Capteur d'image selon l'une quelconque des revendications 1 à 3, dans lequel le support de puce (7) est disposé en dessous du support de circuit (12) qui est muni d'une ouverture (15) au-dessus de la puce de capteur d'image (2).

6. Capteur d'image selon l'une quelconque des revendications 1 à 5, dans lequel des filtres ou une lame de verre (1) sont directement appliqués sur la surface de capteur d'image (2) et/ou des couches sont appliquées sous la forme de couches individuelles ou de combinaisons de couches organiques ou inorganiques.

7. Capteur d'image selon l'une quelconque des revendications 1 à 6, dans lequel le support de circuit (12) est une carte de circuit imprimé qui est constituée de matière plastique renforcée par des fibres ou d'un matériau céramique.

8. Capteur d'image selon l'une quelconque des revendications 1 à 7, dans lequel au moins les liaisons par connexion par fils (4) sont recouvertes entre la puce de capteur d'image (2) et le support de puce (7) par le filtre ou la lame de verre 1.

9. Capteur d'image selon l'une quelconque des revendications 1 à 8, dans lequel toutes les liaisons de connexion par fils (4, 9) sont noyées dans une masse coulée.
